# EUROPEAN PATENT SPECIFICATION

(11) **EP 1 075 072 B1**
(45) Date of publication and mention of the grant of the patent: **16.06.2004**
(21) Application number: 99115575.5
(22) Date of filing: 06.08.1999
(51) Int. Cl.: H02K 1/14, H02K 21/22, H01L 23/467

(54) **Stator for a rotary DC brushless motor**
Stator für einen bürstenlosen Motor
Stator pour un moteur sans balais

(43) Date of publication of application: 07.02.2001
(73) Proprietor: Sunonwealth Electric Machine Industry Co., Ltd., Kaohsiung, Taiwan R.O.C. (TW)
(72) Inventor: Horng, Alex, Kaohsiung, Taiwan, R.O.C. (TW)
(74) Representative: LOUIS- PÖHLAU- LOHRENTZ

(56) References cited:
- EP-A- 0 673 066
- FR-A- 1 197 112
- JP-A- 61 128 763
- US-A- 4 656 381
- US-A- 4 891 567
- US-A- 5 093 599
- US-A- 5 245 236
- US-A- 5 492 458
- US-A- 5 808 390
- US-A- 5 917 262

## Description

### Background of the Invention

### 1. Field of the Invention

The present invention relates to a brushless DC motor to the structure of the stator a brushless DC motor, the stator including a magnetic conductive tube and a pole plate.

### 2. Description of the Related Art

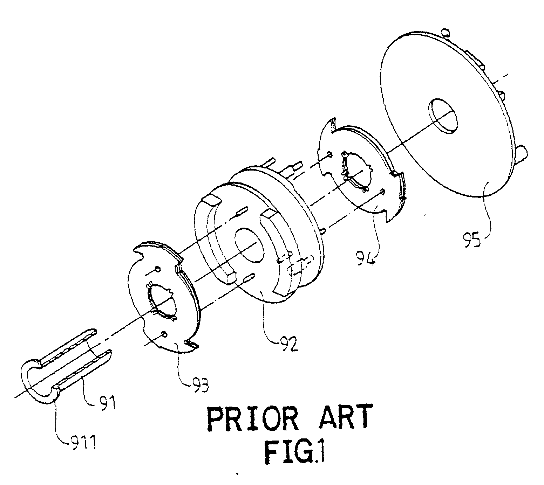

Referring to FIG1, a conventional brushless DC motor and stator comprises a metal tube 91 with outer surface surrounded by a coil 92, an upper pole plate 93, a lower pole plate 94 and a circuit board 95. The upper plate 93 and the lower plate 94 are formed by a plurality of stacked silicon steel plates so as to increase the area adjacent to the permanent magnet of the rotor. Because it consists of a plurality of silicon steel plates, the conventional motor and stator are complex and the cost of manufacture is high, and much more of the material.

Furthermore, one end of the metal tube 91 has an annular flange 911 which is larger than the diameter of the tube. When the other end of metal tube91 being fixed, the annular flange 911 limits the coil 92, the upper plate 93, the lower plate 94 and the circuit board 95, and thus the thickness of annular flange 911 increases the thickness of the stator. In order to decrease the thickness of the stator, the annular flange 911 may be removed for the best design.

Furthermore, U.S. Patent 4,891,567, issued on Jan. 2, 1990 to Fujitani et al., discloses a pole plate having a pole which is bent in a right angle to the pole plate. The poles are bent toward each other, so that the poles cover the outer peripheral space of the coil seat. Thus, the pole plates are pressed and combined on the stator, after coils have been wounded on the coil seat of the stator. However, the poles of the stator are arranged to face each other because coils must first be wounded on the coil seat of the stator, and then the pole plates are pressed on the bobbin to form the stator. The pressing process of pole plates into a bobbin with a coil wound has the disadvantage that the coil wire may be cut or broken ,the bobbin being pressed, and the enameled layer of wires damaged. Wires of the coil suffer from starting current pulses in the long term resulting in the degrading of the coil assembly and resulting in deterioration of rotation of the motor and shortening motor life.

US 5,808,390 discloses a plurality of pole plates extending in relative direction to another pole plate from either of the opposite sides of the stator. It is obvious that the pole of the pole plate shown in this document obstructs the wire-winding process and is capable of cutting the winding wire extending therebetween.

### Summary of the Invention

The primary object of this invention is to provide a stator of a brushless DC motor according to claim 1.

The secondary object of this invention is to provide a stator of a brushless DC motor comprising a magnetic conductive tube, which has a pole plate on one end of the tube, and another pole plate sleeved on the other end of the tube. At least one of the two pole plates has poles which extend in opposite directions to the poles of the other pole plate to form a larger conductive area of the pole plate so as to increase the torque of motor, and to permit freedom of design in accordance with the requirements of the motor without the limitation of space.

The third object of this invention is to provide a stator of a brushless DC motor comprising a magnetic conductive tube, which has a pole plate on one end of the tube, and another pole plate sleeved on the other end of the tube. At least one of the two pole plates has poles which extend in an opposite direction to those of the other pole plate to form a larger conductive area of the pole plate so as to reduce the thickness of pole plate, manufacture processes and the material cost of the pole plate.

The fourth object of this invention is to provide a stator of a brushless DC motor comprising a magnetic conductive tube whose outer surface may wind a coil or support a bobbin for a coil to simplify production processes and reduce the cost of manufacture.

The fifth object of this invention is to provide a stator of a brushless DC motor which has a thinner thickness that uses lesser material and reduces the processes of manufacture, in order to reduce the material and the manufacturing cost.

In accordance with the present invention, a brushless DC motor comprises a magnetic conductive tube, which has a pole plate on one end of the tube and wound coils on the outer surface of the tube, and another pole plate is sleeved on the other end of the tube. The edge of both pole plates have poles extending in opposite directions to form a larger pole edge area to increase magnetic inductive area.

Other objects, advantages and novel features of the invention will become more apparent from the following detailed description when taken in conjunction with the accompanying drawings.

### Brief Description of the Drawings

The present invention will now be described in detail with reference to the accompanying drawings wherein;
Fig. 1 is a perspective exploded view of a conventional brushless DC motor;
Fig. 2 is an exploded perspective view of a stator which is not part of the present invention;
Fig. 3 is a top view of the stator of fig 1;
Fig. 4 is a sectional view, along line 4-4, of the brushless DC motor of fig 3;
Fig. 5 is an exploded perspective view of a brushless DC motor in accordance with the first embodiment of the present invention;
Fig. 6 is a sectional view of the brushless DC motor in accordance with the first embodiment of the present invention;
Fig. 7 is an exploded perspective view of a brushless DC motor in accordance with a second embodiment of the present invention;
Fig. 8 is an exploded perspective view of a brushless DC motor in accordance with a second embodiment of the present invention;
Fig. 9 is an exploded perspective view of a brushless DC motor in accordance with a second embodiment of the present invention;
Fig. 10 is an exploded perspective view of a brushless DC motor in accordance with a third embodiment of the present invention;
Fig. 11 is a sectional view of the brushless DC motor in accordance with the third embodiment of the present invention;
Fig. 12 is an exploded perspective view of a brushless DC motor;
Fig. 13 is a sectional view of the brushless DC motor in accordance with fig 12;
Fig. 14 is a sectional view of the brushless DC motor in accordance with fig 12;
Fig. 15 is an exploded perspective view of a brushless DC motor in accordance with the fourth embodiment of the present invention;
Fig. 16 is a sectional view of the brushless DC motor in accordance with the fourth embodiment of the present invention;
Fig. 17 is an exploded perspective view of a brushless DC motor in accordance with the fifth embodiment of the present invention;
Fig. 18 is a sectional view of the brushless DC motor in accordance with the fifth embodiment of the present invention;
Fig. 19 is an exploded perspective view of a brushless DC motor in accordance with the sixth embodiment of the present invention;
Fig. 20 is a sectional view of the brushless DC motor in accordance with the sixth embodiment of the present invention;
Fig. 21 is an exploded perspective view of a brushless DC motor in accordance with the seventh embodiment of the present invention;
Fig. 22 is a sectional view of the brushless DC motor in accordance with the seventh embodiment of the present invention;
Fig. 23 is an exploded perspective view of a brushless DC motor in accordance with the eighth embodiment of the present invention;
Fig. 24 is a sectional view of the brushless DC motor in accordance with the eighth embodiment of the present invention;
Fig. 25 is an exploded perspective view of the brushless DC motor in accordance with the first embodiment of the present invention;
Fig. 26 is a sectional view of the brushless DC motor in accordance with the first embodiment of the present invention;
Fig. 27 is an exploded perspective view of the brushless DC motor in accordance with the first embodiment of the present invention with fixing member;
Fig. 28 is an exploded perspective view of the brushless DC motor in accordance with the first embodiment of the present invention with case
Fig. 29 is an exploded perspective view of the brushless DC motor in accordance with the first embodiment of the present invention with cooler device.

### Detailed Description of the Invention

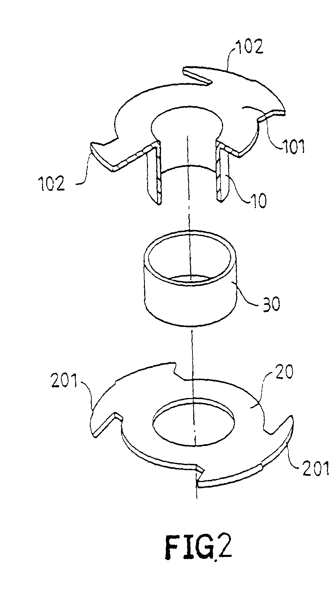

Referring to Fig. 2, a brushless DC motor comprises a magnetic conductive tube 10, a pole plate 20 and a bobbin 30.

The magnetic conductive tube 10 is made of magnetizable material, forming a pole plate 101 on one end of the tube 10, so that the tube 10 and the pole plate 101 together form a body. The plate 101 forms poles 102. An inner periphery of the magnetic conductive tube 10 is provided to contain a bearing (not shown) therein for extending through a shaft of the rotor, and an outer periphery is provided to sleeve the pole plate 20 and the bobbin 30 thereon.

The pole plate 20 sleeved on the outer periphery of the magnetic conductive tube 10 has poles 201 which interact with a permanent magnet of a rotor (not shown) so as to rotate the motor smoothly, and the number of the poles 201 are provided in accordance with the design requirement of motor's pole number.

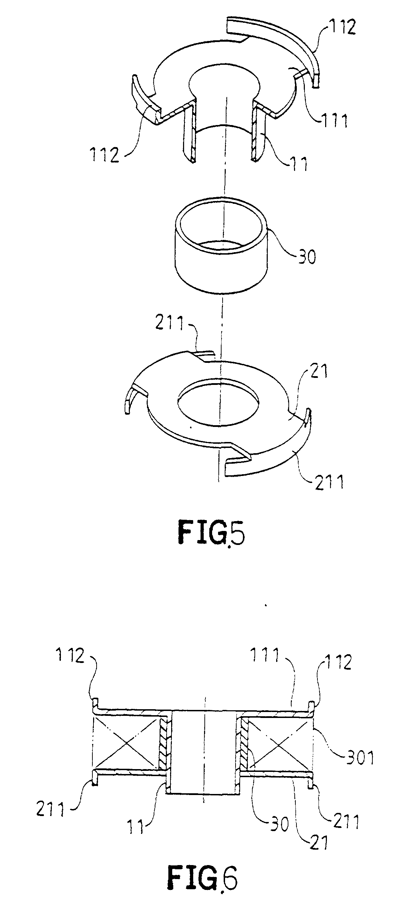

The bobbin 30 is essentially made of insulation material such as plastic, and sleeved on the outer periphery of the magnetic conductive tube 10. The bobbin 30 sleeves tightly or loosely with the outer periphery of the magnetic conductive tube 10 according to design requirements. The bobbin 30 is positioned between the pole plate 101 and the pole plate 20 and coil 301 is wound on the bobbin 30, as shown in Fig. 4. It is easy and convenient to wind the coil 301 on the bobbin 30, before or after the magnetic conductive tube 10 and the bobbin 30 are assembled. Either way may achieve the goal of easy assembly.

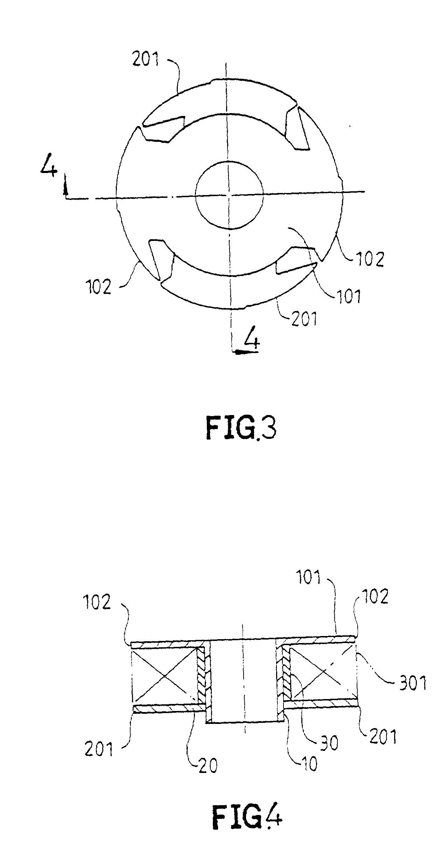

Referring to Figs.3 and 4, which show a stator. The bobbin 30 is held between the pole plate 101 and the pole plate 20, and coil 301 is wound on the outer peripheral of bobbin 30. Insulation layer is needed between coil 301, pole plate 101 and the pole plate 20, to thus form a stator.

Referring to Fig. 5, a brushless DC motor in accordance with the first embodiment of the present invention comprises a magnetic conductive tube 11, a pole plate 21 and a bobbin 30.

The magnetic conductive tube 11 is made of magnetizable material forming a pole plate 111 on one end, the pole plate 111 having poles 112, the outer edge of the poles 112 extending to the opposite direction of the other pole plate 21 so as to increase the induction area of stator to the permanent magnet of a rotor, so that with the thickness of a single plate, the pole plate 111 has a larger induction area. The number of poles 112 are provided in accordance with the design requirement of the motor's pole number. An inner periphery of the magnetic conductive tube 11 is provided to contain a bearing (not shown) therein for extending through a shaft of the rotor, and an outer periphery is provided to sleeve the pole plate 21 and the bobbin 30 thereon.

The pole plate 21 is sleeved on the outer periphery of the magnetic conductive tube 11, the pole plate 21 having poles 211, and the outer edge of the poles 211 extending in an opposite direction to those of the pole plate 11 so as to increase the induction area of stator to the permanent magnet of a rotor, so that the thickness of a single plate of the pole plate 111 has a larger induction area. The number of poles 112 are provided in accordance with the design requirement of the motor's pole number.

The bobbin 30 is the same as in figure 1, and sleeved the outer peripheral of the magnetic conductive tube 10. The bobbin 30 sleeves tightly or loosely around the outer periphery of the magnetic conductive tube 10, the bobbin 30 is positioned between the pole plate 111 and the pole plate 21 therebetween. It is easy and convenient to wind coils on the bobbin 30 before or after the magnetic conductive tube 10 and the bobbin 30 are assembled. Either way may achieve the goal of easy manufacturing.

Fig. 6 shows the situation of the combination of the first embodiment of the present invention. The bobbin 30 is held between the pole plate 111 and the pole plate 21, and coil 301 is wound on the outer peripheral of bobbin 30. An insulated layer is provided between the coil 301, the pole plate 111 and the pole plate 21, and thus it forms a stator.

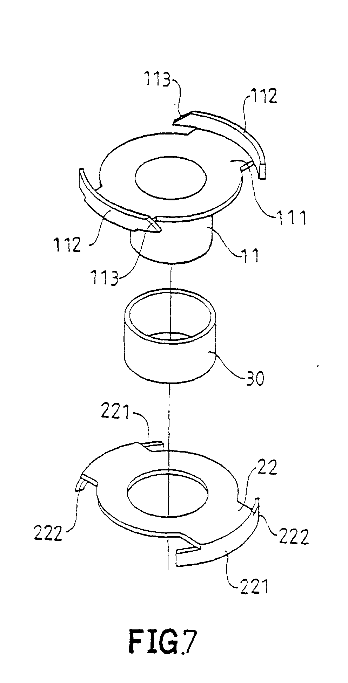

Referring to Fig. 7, a brushless DC motor in accordance with the second embodiment of the present invention comprises a magnetic conductive tube 11, a pole plate 22 and a bobbin 30 corresponding to the second embodiment. The third embodiment further comprises an inclined portion 113, 222 respectively formed on the poles 112, 221 which, unlike the second embodiment, forms an irregular magnetic field. Because of the irregular magnetic field, the stator drives the rotor easily at the beginning of the motor start-up.

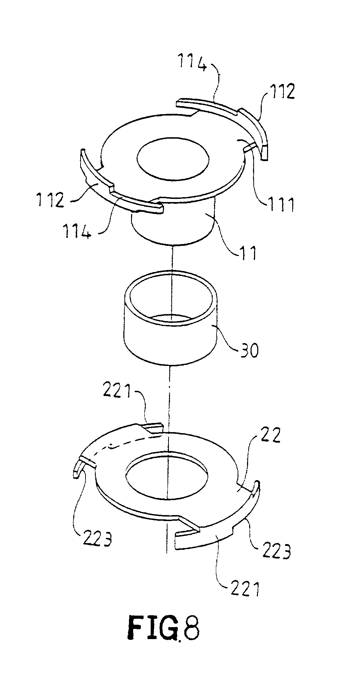

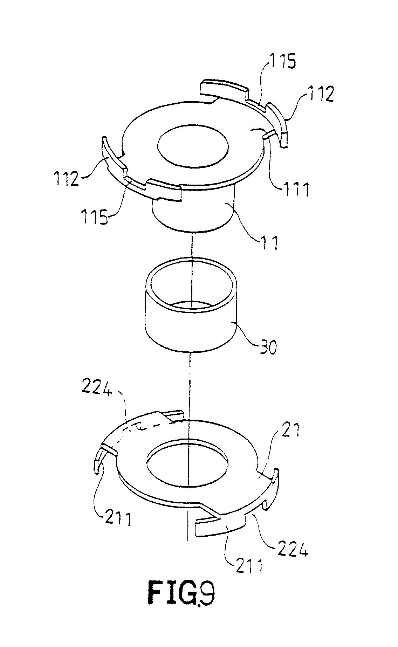

Referring to Fig. 8, the second embodiment of the present invention further comprises a magnetic conductive tube 11, a pole plate 22 and a bobbin 30. The second embodiment further comprises a lower portion 114, 223 instead of the inclined portion 113, 222 respectively formed on the poles 112, 221 to form an irregular magnetic field. And, the third embodiment further comprises a recessed portion 115, 224 respectively formed on the poles 112, 221 to form an irregular magnetic field, as shown in Fig. 9. Because of the irregular magnetic field, the stator drives the rotor easily at the beginning of the motor start-up.

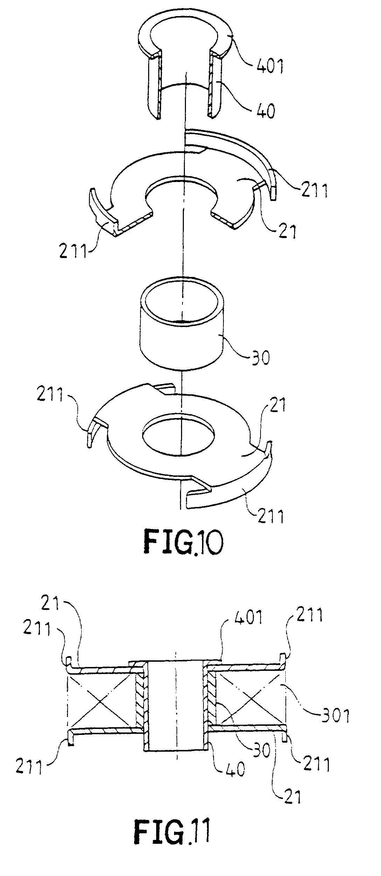

Referring to Fig. 10, a brushless DC motor in accordance with the third embodiment of the present invention comprises two pole plates 21, a bobbin 30 and a magnetic conductive tube 40.

The magnetic conductive tube 40 is made of magnetizable material, forming an annular flange 401 on one end so as to hold the pole plate 21 in place. An inner periphery of the magnetic conductive tube 40 is provided with a bearing (not shown) therein for extending through a shaft of the rotor, and an outer surface to sleeve the two pole plates 21 and the bobbin 30 thereon.

The number of pole plates 21 is more than two, the plate being sleeved on the outer surface of the magnetic conductive tube 40 to be held in place by the annular flange 401. The pole plate 21 has poles 211, the outer edge of the poles 211 extending into the opposite direction to those of the pole plate 11 so as to increase the induction area of the stator relative to the permanent magnet of a rotor, so that the thickness of a single plate of the pole plate 111 has a larger induction area. The number of poles 112 are provided in accordance with the design requirement of the motor's pole number.

The bobbin 30 is essentially made of insulation material such as plastic, and was sleeved to the outer peripheral of the magnetic conductive tube 10. The bobbin 30 sleeves tightly or loosely on the outer surface of the magnetic conductive tube 10. The bobbin 30 is positioned between the pole plate 101 and the pole plate 20 therebetween and wire are coiled on the bobbin 30 thereon to form a coil 301. It is easy and convenient to wind the coil 301 on the bobbin 30 before or after the magnetic conductive tube 10 and the bobbin 30 are assembled. Either way may achieve the goal of easy assembly.

Fig. 11 shows the situation of the combination of the third embodiment of the present invention. The bobbin 30 is held between the two pole plates 21, and the coil 301 wound on the outer surface of bobbin 30. An insulated layer is provided between the coil 301 and the two pole plates 21, to thus form a stator.

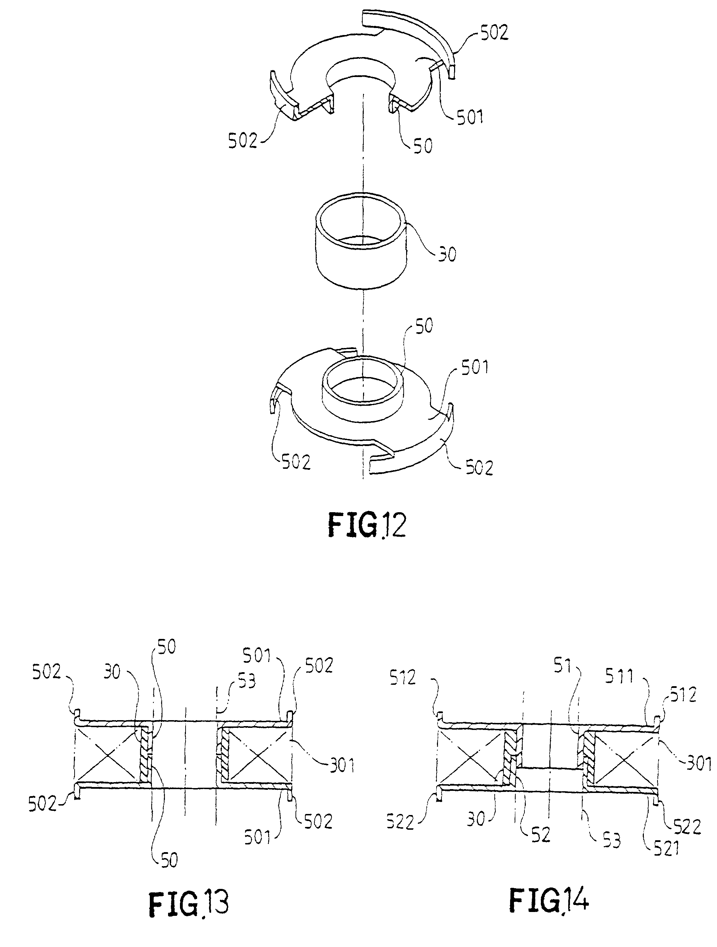

Referring to Fig. 12, a brushless DC motor comprises a bobbin 30 and two magnetic conductive tubes 50.

The magnetic conductive tube 50 is made of magnetizable material forming a pole plate 501 on one end, the pole plate 501 having poles 502, the outer edge of the poles 502 extending in an opposite direction relative to those of the other pole plate 501 so as to increase the induction area of the stator relative to the permanent magnet of a rotor, so that with the thickness of a single plate, the pole plate 501 has a larger induction area. The number of poles 502 are provided in accordance with the design requirement of the motor's pole number. The magnetic conductive tubes 50 are attached to each other and form an inner peripheral which is provided to contain a bearing (not shown) therein for extending through a shaft of the rotor, and an outer surface is provided to sleeve the pole plate 21 and the bobbin 30 thereon.

The bobbin 30 is essentially made of insulation material such as plastic, and was sleeved to the outer surface of the magnetic conductive tube 50. The bobbin 30 is sleeved tightly or loosely on the outer surface of the two attached magnetic conductive tube 50. The bobbin 30 is positioned between the two pole plates 501 therebetween. Coil 301 is wound on the bobbin 30. It is easy and convenient to wind the coil 301 on the bobbin 30 before or after the magnetic conductive tube 50 and the bobbin 30 are assembled. Either way may achieve the goal of easy assembly.

Fig. 13 shows the situation of a stator. The bobbin 30 is sleeved to the outer surface of the two attached magnetic conductive tube 50, and coil 301 is wound on the outer surface of bobbin 30. An insulated layer is provided between the coil 301 and the pole plates 501), thus forming a stator to be fixed onto a supporter 53.

Referring to Fig. 14, a stator comprises two magnetic conductive tubes 51 and 52 having different diameter. The magnetic conductive tube 51 has a smaller diameter than the magnetic conductive tube 52 such that the outer surface of the magnetic conductive tube 51 is held in the inner surface of the magnetic conductive tube 52. The bobbin 30 is sleeved to the outer surface of the magnetic conductive tube with the large diameter. The coil 301 is wound on the outer surface of bobbin 30 and an insulated layer is provided between the coil 301 and the pole plates 511, thus forming a stator to be fixed on to a supporter 53 by the magnetic conductive tube with the smaller diameter.

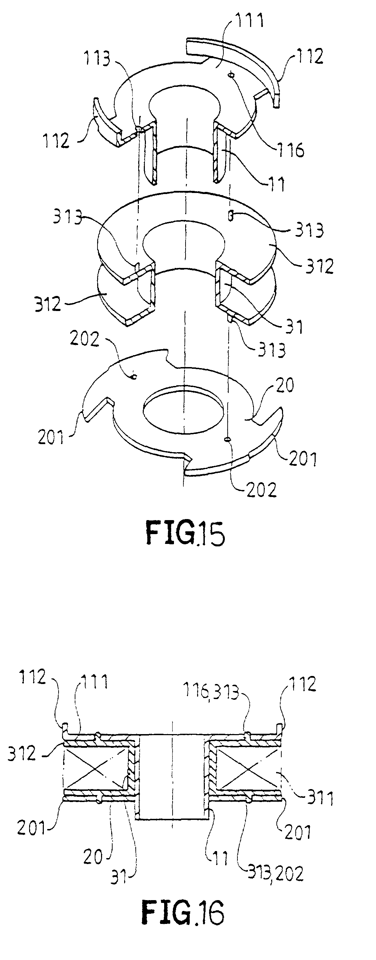

Referring to Fig. 15, a brushless DC motor in accordance with the fourth embodiment of the present invention comprises a magnetic conductive tube 11, a pole plate 20 and a bobbin 31.

The magnetic conductive tube 11 is made of magnetizable material forming a pole plate 111 on one end, the pole plate 111 having poles 112, the outer edge of the poles 112 extending in an opposite direction than those of the other pole plate 21 so as to increase the induction area of the stator relative to the permanent magnet of a rotor, so that the thickness of a single plate of the pole plate 111 has a larger inductive area. The number of poles 112 are provided in accordance with the design requirement of the motor's pole number. An inner periphery of the magnetic conductive tube 11 is provided to contain a bearing (not shown) therein for extending through a shaft of the rotor, and an outer surface is provided to sleeve the pole plate 21 and the bobbin 30 thereon.

More than one pole plate 20 are sleeved to the outer surface of the magnetic conductive tube 10. It has poles 201 to interact with a permanent magnet of a rotor (not shown) so as to rotate the motor smoothly, and the number of poles 201 are provided in accordance with the design requirement of the motor's pole number.

The bobbin 31 is essentially made of insulation material such as plastic, and sleeved to the outer surface of the magnetic conductive tube 11. The bobbin 31 sleeves tightly or loosely to the outer surface of the magnetic conductive tube 11, and is positioned between the pole plate 111 and the pole plate 20 and coil 311 being wound on the bobbin 31. It is easy and convenient to wind the coil 311 on the bobbin 31 before or after the magnetic conductive tube 11 and the bobbin 31 are assembled. Either way may achieve the goal of easy assembly.

The fourth embodiment further discloses a positioning structure, comprises a plurality of holes 116, 202 respectively defined by the pole plates 111, 20 thereon. On two ends of the bobbin 31 are two discs 312 which limit the coil therebetween and insulate the coil from the plates 111, 20. And the two plates 312 have a plurality of posts 313 extending outward therefrom. The posts 313 fit into the holes 116, 202 so as to position easily and accurately the magnetic conductive tube 11 and the plate 111,20 on the bobbin 31. Because two discs 312 insulate the coil from the plates 111, 20, there is no need to provide an insulated layer which insulates the coil 301 from the plates 111, 20.

Fig. 16 shows the situation of the combination of the fourth embodiment of the present invention. The bobbin 31 is held between the pole plate 111 and the pole plate 20, and coil 311 is wound on the outer surface of bobbin 31, and thus forms a stator.

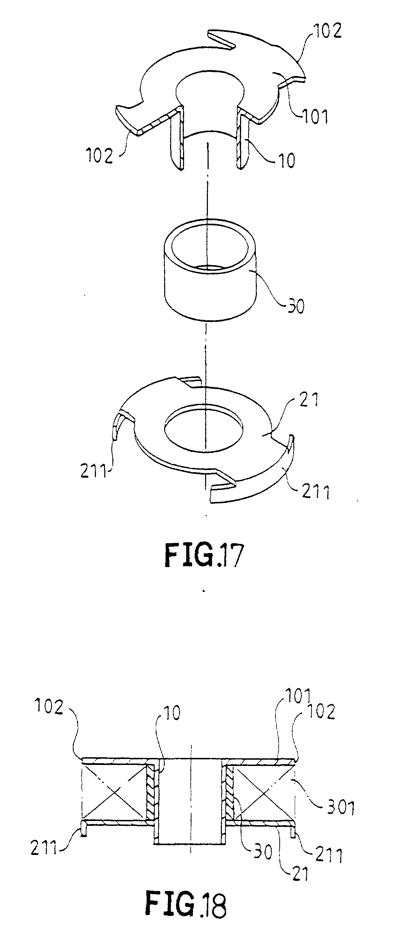

Referring to Fig. 17, a brushless DC motor in accordance with the fifth embodiment of the present invention comprises a magnetic conductive tube 10, a pole plate 21 and a bobbin 30.

The magnetic conductive tube 10 is made of magnetizable material, forming a pole plate 101 on one end of the tube 10 so that the tube 10 and the pole plate 101 together form a body. The plate 101 forms poles 102. An inner periphery of the tube 10 is provided to contain a bearing (not shown) therein for extending through a shaft of the rotor, and an outer surface is provided to sleeve the pole plate 20 and the bobbin 30 thereon. The number of poles 102 are provided in accordance with the design requirement of the motor's pole number.

More than one pole plate 21 are sleeved on the outer surface of the magnetic conductive tube 11, the pole plate 21 having poles 211, the outer edge of the poles 211 extend in an opposite direction than the other pole plate 11 so as to increase the induction area of the stator to the permanent magnet of a rotor, so that with the thickness of a single plate, the pole plate 111 has a larger induction area. The number of poles 112 are provided in accordance with the design requirement of the motor's pole number.

The bobbin 30 has been disclosed as above-mentioned, the timing of the winding the coil can be selected as required. Therefore the description is not repeated here.

Fig. 18 shows the situation of the combination of the fifth embodiment of the present invention. The bobbin 30 is held between the pole plate 101 and the pole plate 21, and coil 301 is wound on the outer surface of bobbin 30 An insulating layer is provided between the coil 301, pole plate 101 and the pole plate 21, thus forming a stator.

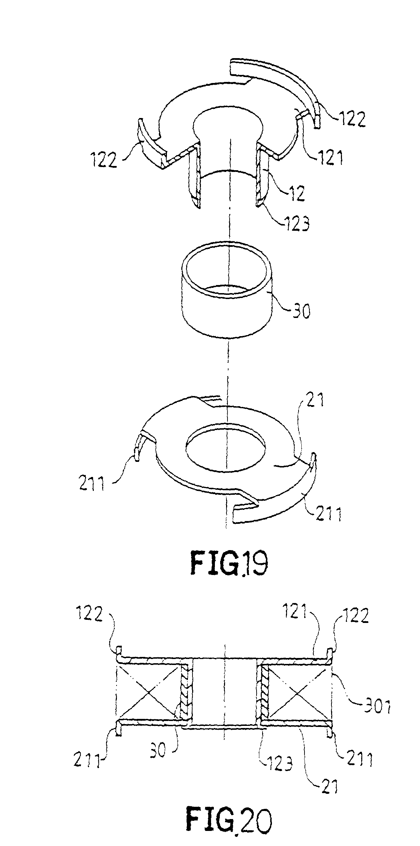

Referring to Fig. 19, a brushless DC motor in accordance with the sixth embodiment of the present invention comprises a magnetic conductive tube 12, a plate 21 and a bobbin 30.

The magnetic conductive tube 12 is made of magnetizable material forming a pole plate 121 on one end, the pole plate 121 having poles 122, the outer edge of the poles 122 extend in an opposite direction than the other pole plate 21 so as to increase the induction area of the stator to the permanent magnet of a rotor, so that with the thickness of a single plate, the pole plate 121 has a larger induction area. The number of poles 122 are provided in accordance with the design requirement of motor's pole number. An inner peripheral of the magnetic conductive tube 12 is provided to contain a bearing (not shown) therein for extending through a shaft of the rotor, and an outer surface is provided to sleeve the pole plate 21 and the bobbin 30 thereon. The end of the magnetic conductive tube 12 has provided thereon an annular flange 123 with a smaller diameter than the diameter of the pole plate 121. The annular flange 123 can be processed by bending press to fix the bobbin 30 in place.

The pole plate 21 and the bobbin 30 have been disclosed as above-mentioned, the timing of winding the coil can be selected as required.

Fig. 20 shows the situation of the combination of the sixth embodiment of the present invention. The bobbin 30 is held between the pole plate 121 and the pole plate 21, an annular flange 123 is bent and positioned to insure that the pole plate 21 and the bobbin 30 are held in place, and coil 301 is wound on the outer surface of bobbin 30. An insulated layer is provided between the coil 301, the pole plate 121 and the pole plate 21, thus forming a stator.

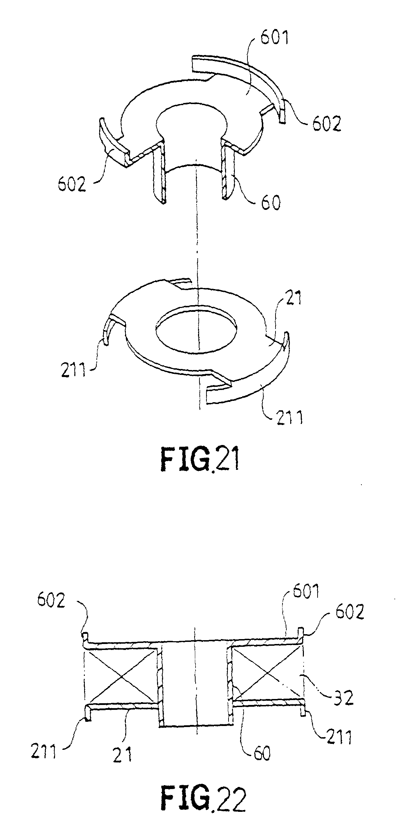

Referring to Fig. 21, a brushless DC motor in accordance with the seventh embodiment of the present invention comprises a pole plate 21 and a magnetic conductive tube 60.

The magnetic conductive tube 60 is made of magnetizable material forming a pole plate 601 on one end, the pole plate 601 having poles 602, the outer edge of the poles 602 extend in an opposite direction than the other pole plate 21 so as to increase the induction area of stator to the permanent magnet of a rotor, so that with the thickness of a single plate, the pole plate 601 has a larger induction area. The number of poles 602 are provided in accordance with the design requirement of the motor's pole number. An inner periphery of the magnetic conductive tube 60 is provided to contain a bearing (not shown) therein for extending through a shaft of the rotor. The contact surface between coil 32 and outer surface of magnetic conductive tube 60 and pole plate 601 need insulation treatment and forms an insulation layer. Therefore, the outer surface of magnetic conductive tube 60 provides pole plate 21 to sleeve onto and the coil 32 may be wound onto it.

The pole plate 21 is sleeved on the outer surface of the magnetic conductive tube 11, the pole plate 21 having poles 211, the outer edge of the poles 211 extending in an opposite direction than the other pole plate 602 so as to increase the induction area of stator to the permanent magnet of a rotor, so that with the thickness of a single plate, the pole plate 21 has a larger induction area. The number of poles 211 are provided in accordance with the design requirement of the motor's pole number. The contact surface between the pole plate 21 and coil 32 needs insulation treatment to form an insulated layer.

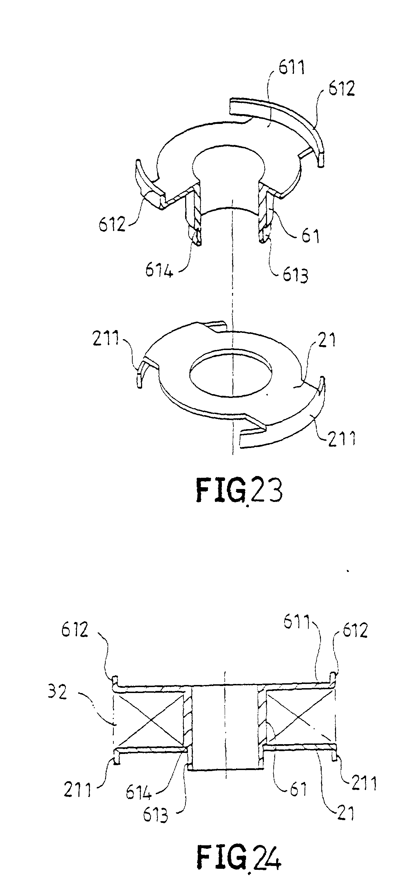

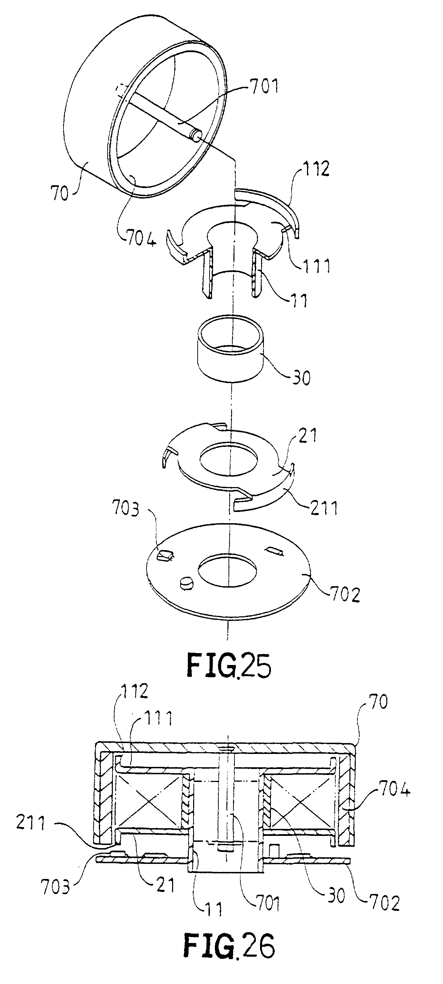

Referring to Fig. 23, a brushless DC motor in accordance with the eighth embodiment of the present invention comprises a pole plate 21 and a magnetic conductive tube 61 which is the same as the ninth embodiment. The contact surface between coil 32 and the pole plate 21 and pole plate 611 needs insulation treatment to form an insulated layer. The magnetic conductive tube 61 further comprises a smaller diameter at an end 613.A ladder-shaped corner 614 is formed by the different diameter on the outer surface of the magnetic conductive tube 61 for attaching and positioning the pole plate 21 (as shown in Fig. 24). A coil 32 may be wound on the outer surface of the magnetic conductive tube 61at the section between the pole plate 611 and the pole plate 21, and thus it forms a stator.

Referring to Fig. 25 and 26, a rotor 70 and a circuit board 702 are assembled to form a motor corresponding to that of the first embodiment of the present invention. The first embodiment mainly comprises the magnetic conductive tube 11, the pole plate 21, the bobbin 30, a rotor 70 and a circuit board 702. The circuit board 702 mainly sleeves to the outer surface of the magnetic conductive tube 11 so as to allow a Hall IC 703 of the circuit board 702 to respond to a permanent magnet 704 of the rotor 70. An inner periphery of the magnetic conductive tube 11 is provided to contain a bearing element therein for extending through a shaft 701 of the rotor 70 to form a brushless motor.

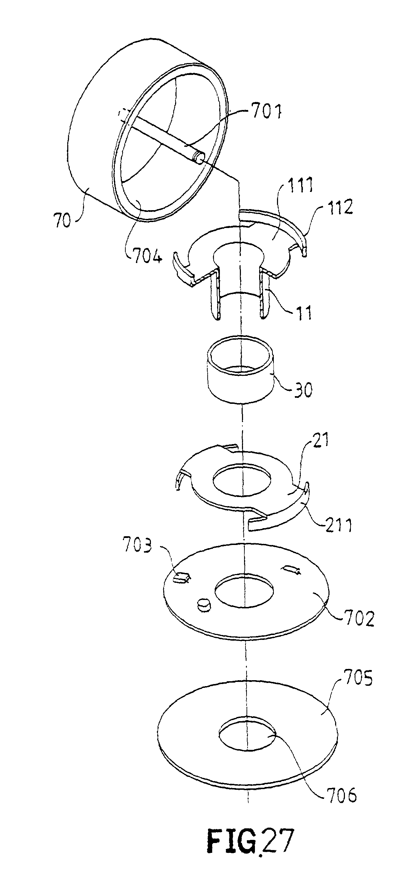

Referring to Fig. 27, a fixing member 705 is combined with the present invention, The fixing member 705 like a substrate or a case of another product having a hole 706 through which to combine with the magnetic conductive tube 11 by means of an interference fit between different diameters, or by any other combination method.

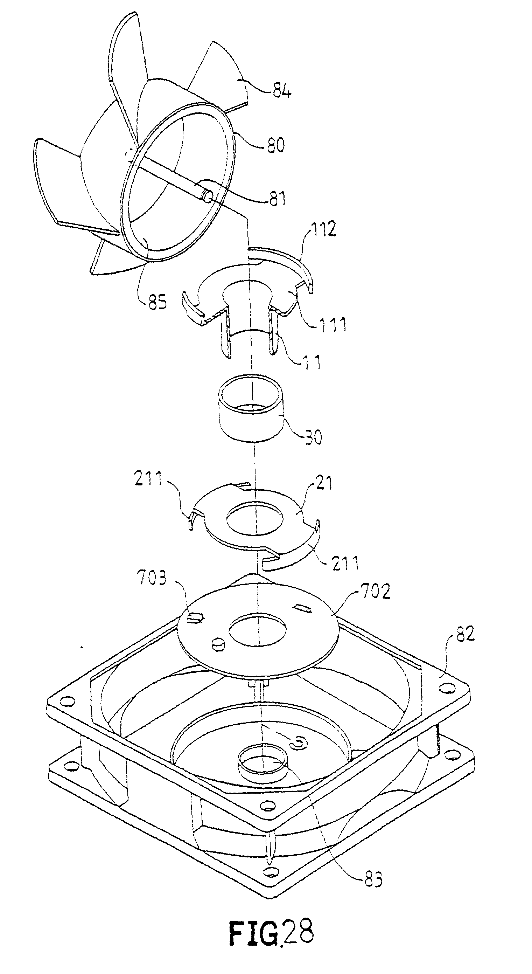

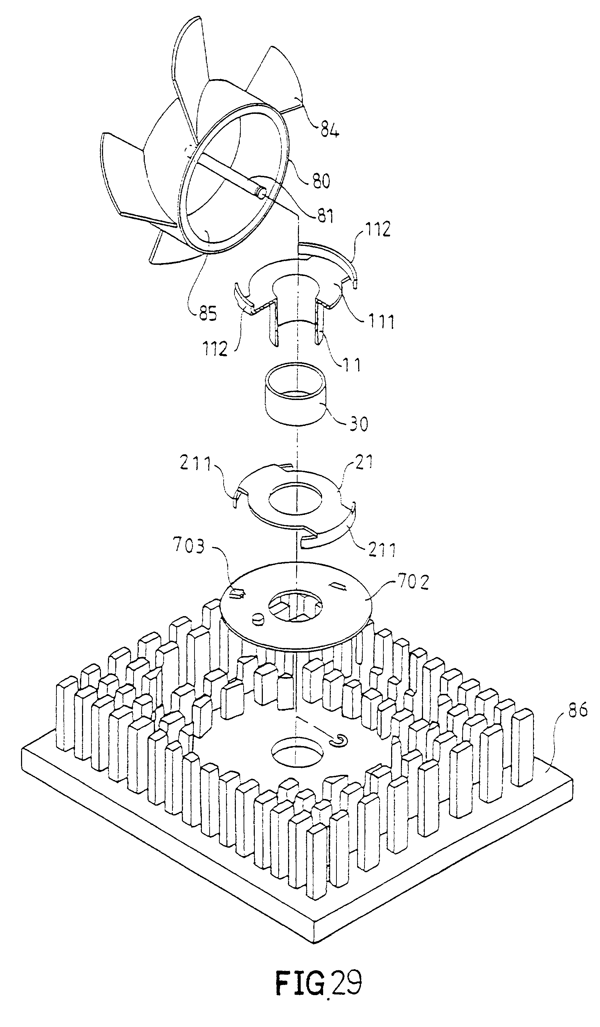

Fig. 28 shows the present invention brushless DC. motor (not labeled) and a case 82 combined together to form a cooler device which consists of the magnetic conductive tube 11, the pole plate 21, the bobbin 30 and a circuit board 702. Then the magnetic conductive tube 11 is held in a hole 83 of the case 82 or a conventional heat sink 86 with fins or posts(as shown in Fig. 29). The inner peripheral of magnetic conductive tube 11 is provided to contain a bearing element(not shown) for extending through a shaft 81 of impeller 80. The impeller 80 further comprises a plurality of blades 84 and permanent magnets 85. Therefore, the combined cooler device may achieve the cooling results.

A brushless DC motor of the present invention as defined in Claim 1 reduces the complexity and cost of manufacture of conventional metal tube and pole plate, and reduces the thickness of a stator by means of reducing the thickness of the annular flange protruded on the outside of the pole plate.

## Claims

1. A stator for a rotary brushless DC motor comprising:
A magnetic conductive tube (10, 11, 12) made of magnetizable material and a first pole plate (101, 111, 121) formed on one end of the magnetic conductive tube, the first pole plate (101, 111, 121) further including a closed annular portion and a plurality of poles (102, 112, 122) extending therefrom;
a second pole plate (20, 21, 22) sleeved to the magnetic conductive tube (10, 11, 12), held on the magnetic conductive tube (20, 21, 22) and further comprising a closed annular portion and a plurality of poles (102, 112, 122) extending therefrom;
a single coil (301) wound around the magnetic conductive tube (10, 11, 12) and insulated with respect to the first and second pole plates (101, 111, 121) and located axially between the first pole plate and the second pole plate
**characterized in**
**that** the poles (102, 112, 122) of the first pole plate (101, 111, 121) extend axially from the closed annular portion of the first pole plate (101, 111, 121) and away from the coil to define an axial length of the poles larger than the axial thickness of the closed annular portion of the first pole plate (101, 111, 121)
and in that either the poles of the second pole plate (20, 21, 22) extend only in the plane of the closed annular portion of the second pole plate (20, 21, 22) or the poles of the second pole plate (20, 21, 22) extend axially from the closed annular portion of the second pole plate (20, 21, 22) and away from the coil to define an axial length of the pole plates larger than the axial thickness of the closed annular portion of the second pole plate (20, 21, 22).

2. The stator as defined in Claim 1, wherein the magnetic conductive tube (10, 11, 12) and a pole plate (101, 111, 121) form a single member.

3. The stator as defined in Claim 1, wherein one end of the magnetic conductive tube (10, 11, 12) opposite said one end on which said first pole plate (101, 111, 121) is formed cylindrical.

4. The stator as defined in Claim 1, wherein one end of the magnetic conductive tube (12, 60) opposite said one end on which said first pole plate (101, 111, 121) is formed includes an annular flange (123) having a diameter smaller than a diameter of the first pole plate (101, 111, 121).

5. The stator as defined in Claim 1, wherein one of the pole plates (111, 21) has a recessed portion (115, 224) which forming an irregular magnetic field in order to let the stator drive the rotor easily during start-up.

6. The stator as defined in Claim 1, wherein one of the pole plates (111, 21) has an inclined portion (114, 223) or has a first portion (114, 223) with a smaller axial thickness than a second portion of the pole plate forming an irregular magnetic field in order to let the stator drive the rotor easily during start-up.

7. The stator as defined in Claim 1, comprising:
a combined tube/plate member including the magnetic conductive tube (10, 11, 12) made of magnetizable material and the first pole plate (101, 111, 121) formed on one end of the magnetic conductive tube (10, 11, 12); and
a bobbin (30, 31) made of insulating material located between the second pole plate (20, 21, 22) and the first pole plate (101, 111, 121), and insulated from the magnetic conductive tube (10, 11, 12) and the first pole plate (101, 111, 121).

8. The stator as defined in Claim 7, wherein the bobbin (30, 31) has two discs (312) on two ends, a coil (311) being wound in between the two discs (312).

9. The stator as defined in Claim 8, wherein the discs (312) further comprises a plurality of posts (313) arranged to fit into a plurality of holes (116, 202) on the pole plates (111, 20).

10. The stator as defined in Claim 1, wherein a bobbin (30, 31) made of insulating material located between the second pole plate (20, 21, 22) and the first pole plate (101, 111, 121), and insulated from the magnetic conductive tube (10, 11, 12) and the first pole plate (101, 111, 121), a coil (311) being wound around the bobbin (30, 31) and insulated from the two pole plates (101, 111, 121, 20, 21, 22) and magnetic conductive tube (10, 11, 12);

## Patentansprüche

1. Stator für einen rotierenden bürstenlosen Gleichstrommotor mit
einem magnetisch leitenden Rohr (10, 11, 12) aus einem magnetisierbaren Material, und einer ersten Polplatte (101, 111, 121), die an einem Ende des magnetisch leitenden Rohres ausgebildet ist, wobei die erste Polplatte (101, 111, 121) außerdem einen geschlossenen ringförmigen Abschnitt und eine Anzahl Pole (102, 112, 122) aufweist, die sich vom ringförmigen Abschnitt wegerstrecken,
einer zweiten Polplatte (20, 21, 22), die mit dem magnetisch leitenden Rohr (10, 11, 12) verbunden und an diesem festgehalten ist, wobei die zweite Polplatte außerdem einen geschlossenen ringförmigen Abschnitt und eine Anzahl von diesem wegstehende Pole (102, 112, 122) aufweist, und
mit einer einzigen Spule (301), die um das magnetisch leitende Rohr (10, 11, 12) gewickelt ist, und die in bezug auf die erste und zweite Polplatte (101, 111, 121) isoliert und axial zwischen der ersten und der zweiten Polplatte angeordnet ist,
**dadurch gekennzeichnet,**
**dass** die Pole (102, 112, 122) der erste Polplatte (101, 111, 121) sich axial vom geschlossenen ringförmigen Abschnitt der ersten Polplatte (101, 111, 121) wegerstrecken und von der Spule wegstehen, um eine axiale Länge der Pole zu bestimmen, die größer ist als die axiale Dicke des geschlossenen ringförmigen Abschnittes der ersten Polplatte (101, 111, 121), und
**dass** die Pole der zweiten Polplatte (20, 21, 22) sich entweder in der Ebene des geschlossenen ringförmigen Abschnittes der zweiten Polplatte (20, 21, 22) erstrecken, oder dass die Pole der zweiten Polplatte (20, 21, 22) sich axial vom geschlossenen ringförmigen Abschnitt der zweiten Polplatte (20, 21, 22) wegerstrecken und von der Spule wegstehen, um eine axiale Länge der Polplatte zu bestimmen, die größer ist als die axiale Dicke des geschlossenen ringförmigen Abschnittes der zweiten Polplatte (20, 21, 22).

2. Stator nach Anspruch 1, wobei das magnetisch leitende Rohr (10, 11, 12) und eine Polplatte (101, 111, 121) ein einteiliges Element bilden.

3. Stator nach Anspruch 1, wobei ein Ende des magnetisch leitenden Rohres (10, 11, 12) dem einen Ende gegenüberliegt, an dem die erste Polplatte (101, 111, 121) zylindrisch ausgebildet ist.

4. Stator nach Anspruch 1, wobei ein Ende des magnetisch leitenden Rohres (12, 60), das dem einen Ende gegenüberliegt, an dem die erste Polplatte (101, 111, 121) ausgebildet ist, einen ringförmigen Flansch (123) aufweist, der einen Durchmesser besitzt, der kleiner ist als ein Durchmesser der ersten Polplatte (101, 111, 121).

5. Stator nach Anspruch 1, wobei eine der Polplatten (111, 21) einen ausgesparten Abschnitt (115, 224) besitzt, durch den ein unregelmäßiges Magnetfeld gebildet wird, so dass der Stator den Rotor während des Anlaufes leichter antreibt.

6. Stator nach Anspruch 1, wobei eine der Polplatten (111, 21 ) einen geneigten Abschnitt (114, 223) oder einen ersten Abschnitt (114, 223) mit einer kleineren axialen Dicke besitzt als ein zweiter Abschnitt der Polplatte, um ein unregelmäßiges Magnetfeld zu bilden, durch das der Stator den Rotor während des Anlaufens leichter antreibt.

7. Stator nach Anspruch 1
mit einem kombinierten Rohr/Platte-Element, das ein magnetisch leitendes Rohr (10, 11, 12) aus einem magnetisierbaren Material aufweist, wobei die erste Polplatte (101, 111, 121) an einem Endes des magnetisch leitenden Rohres (10, 11, 12) ausgebildet ist, und
mit einer kleinen Spule (30, 31) aus Isoliermaterial, die zwischen der zweiten Polplatte (20, 21, 22) und der ersten Polplatte (101, 111, 121) angeordnet ist, und die gegen das magnetisch leitende Rohr (10, 11, 12) und gegen die erste Polplatte (101, 111, 121) isoliert ist.

8. Stator nach Anspruch 7, wobei die kleine Spule (30, 31) an ihren beiden Enden je eine Scheibe (312) besitzt, wobei zwischen den beiden Scheiben (312) eine Spule (311) gewickelt ist.

9. Stator nach Anspruch 8, wobei die Scheiben (312) außerdem eine Anzahl Bolzen (313) aufweisen, die derartig angeordnet sind, dass sie in eine Anzahl Löcher (116, 202) in den Polplatten (111, 20) hineinpassen.

10. Stator nach Anspruch 1, wobei eine kleine Spule (30, 31) aus Isoliermaterial zwischen der zweiten Polplatte (20, 21, 22) und ersten Polplatte (101, 111, 121) angeordnet und gegen das magnetisch leitende Rohr (10, 11, 12) und gegen die erste Polplatte (101, 111, 121) isoliert ist, und wobei eine Spule (311) um die kleine Spule (30, 31) gewickelt und gegen die beiden Polplatten (101, 111, 121; 20, 21, 22) und gegen das magnetisch leitende Rohr (10, 11, 12) isoliert ist.

## Revendications

1. Un stator pour moteur rotatif sans balai alimenté en courant continu comprenant :
un tube conducteur magnétique (10, 11, 12) réalisé en un matériau magnétisable et une première plaque polaire (101, 111, 121) créée à une extrémité du tube conducteur magnétique, la première plaque polaire (101, 111, 121) comportant par ailleurs une portion annulaire fermée et une pluralité de pôles (102, 112, 122) qui en partent ;
une seconde plaque polaire (20, 21, 22) emmanchée sur le tube conducteur magnétique (10, 11, 12), maintenue sur le tube conducteur magnétique (20, 21, 22) et comportant par ailleurs une portion annulaire fermée et une pluralité de pôles (102, 112, 122) qui en partent ;
un bobinage unique (301) enroulé autour du tube conducteur magnétique (10, 11, 12) et isolé par rapport aux première et seconde plaques polaires (101, 111, 121) et situées axialement entre la première plaque polaire et la seconde plaque polaire,
**caractérisé en ce que**
les pôles (102, 112, 122) de la première plaque polaire (101, 111, 121) partent axialement depuis la portion annulaire fermée de la première plaque polaire (101, 111, 121) en s'éloignant du bobinage de façon à définir une longueur axiale des pôles supérieure à l'épaisseur axiale de la portion annulaire fermée de la première plaque polaire (101, 111, 121), et **en ce que**, ou bien les pôles de la seconde plaque polaire (20, 21, 22) ne s'étendent que dans le plan de la portion annulaire fermée de la seconde plaque polaire (20, 21 ,22), ou bien les pôles de la seconde plaque polaire (20, 21, 22) s'étendent axialement depuis la portion annulaire fermée de la seconde plaque polaire (20, 21, 22) en s'éloignant du bobinage, de manière à définir une longueur axiale des plaques polaires supérieure à l'épaisseur axiale de la portion annulaire fermée de la seconde plaque polaire (20, 21, 22).

2. Le stator de la revendication 1, dans lequel le tube conducteur magnétique (10, 11, 12) et une plaque polaire (101, 111, 112) constituent ensemble une pièce unique.

3. Le stator de la revendication 1, dans lequel une extrémité du tube conducteur magnétique (10, 11, 12) opposée à ladite extrémité sur laquelle ladite première plaque polaire (101, 111, 121) a une forme cylindrique.

4. Le stator de la revendication 1, dans lequel une extrémité du tube conducteur magnétique (12, 60) opposée à ladite extrémité sur laquelle ladite première plaque polaire (101, 111, 121) a une forme comportant un boudin annulaire (123) ayant un diamètre inférieur à un diamètre de la première plaque polaire (101, 111, 121).

5. Le stator de la revendication 1, dans lequel une des deux plaques polaires (111, 21) présente une portion en creux (115, 224) qui créée un champ magnétique irrégulier en vue d'amener le stator à entraîner facilement le rotor au cours du démarrage.

6. Le stator de la revendication 1, dans lequel une des plaques polaires (111, 21) présente une portion inclinée (114, 223), ou présente une première portion (114, 223) ayant une épaisseur axiale plus faible qu'une seconde portion de la plaque polaire, en créant ainsi un champ magnétique irrégulier en vue d'amener le stator à entraîner facilement le rotor au cours du démarrage.

7. Le stator de la revendication 1 comprenant :
une pièce combinée tube/plaque se composant du tube conducteur magnétique (10, 11, 12) en matériau magnétisable et la première plaque polaire (101, 111, 121) créée sur une extrémité du tube conducteur magnétique (10, 11, 12) ; et
une bobine (30, 31) en matériau isolant située entre la seconde plaque polaire (20, 21, 22) et la première plaque polaire (101, 111, 121) et isolée du tube conducteur magnétique (10, 11, 12) et de la première plaque polaire (101, 111, 121).

8. Le stator de la revendication 7 dans lequel la bobine (30, 31) comprend deux disques (312) aux deux extrémités et un bobinage (311) enroulé entre les deux disques (312).

9. Le stator de la revendication 8 dans lequel les deux disques (312) portent par ailleurs une pluralité de picots (313) agencés de manière à se loger dans une pluralité de trous (116, 202) pratiqués dans les plaques polaires (111, 20).

10. Le stator selon la revendication 1 dans lequel une bobine (30, 31) en matériau isolant est située entre la seconde plaque polaire (20, 21, 22) et la première plaque polaire (101, 111, 121), et est isolée du tube conducteur magnétique (10, 11, 12) et la première plaque polaire (101, 111, 121), un bobinage (311) étant enroulé autour de la bobine (30, 31) et isolé des deux plaques polaires (101, 111, 121, 20, 21, 22) et du tube conducteur magnétique (10, 11, 12).
